Europäisches Patentamt

European Patent Office

Office européen des brevets

(19)

(11) EP 0 782 251 B1

(12) FASCICULE DE BREVET EUROPEEN

(45) Date de publication et mention
de la délivrance du brevet:
**24.10.2001 Bulletin 2001/43**

(51) Int Cl.$^7$: **H03F 3/08**

(21) Numéro de dépôt: **96402898.9**

(22) Date de dépôt: **26.12.1996**

(54) **Dispositif de détection comportant des moyens d'asservissement automatique d'une photodiode PIN**

Detektor mit selbsttätiger Regelung der Vorspannung einer PIN-Fotodiode

Detector with automatic bias control of a PIN photodiode

(84) Etats contractants désignés:
**DE FR GB**

(30) Priorité: **29.12.1995 FR 9515744**

(43) Date de publication de la demande:
**02.07.1997 Bulletin 1997/27**

(73) Titulaire: **THOMSON BROADCAST SYSTEMS**
**95801 Cergy-Pontoise Cedex (FR)**

(72) Inventeurs:
• **Claverie, Claude**
**92050 Paris la Défense 5 (FR)**
• **Boisseau, Daniel**
**92050 Paris la Défense 5 (FR)**

(74) Mandataire: **Brykman, Georges**
**THOMSON multimedia,**
**46 quai A. Le Gallo**
**92648 Boulogne Cédex (FR)**

(56) Documents cités:
**EP-A- 0 402 044**       **DE-A- 2 841 940**
**DE-A- 3 543 677**       **FR-A- 2 527 027**
**GB-A- 2 135 551**       **GB-A- 2 181 832**
**GB-A- 2 194 406**

• **EDN ELECTRICAL DESIGN NEWS, vol. 37, no.
11, 21 Mai 1992, pages 155-160, 162,
XP000305515 GRAEME J: "CIRCUIT OPTIONS
BOOST PHOTODIODE BANDWIDTH"**
• **PATENT ABSTRACTS OF JAPAN vol. 9, no. 106
(E-313) [1829] , 10 Mai 1985 & JP 59 230307 A
(MATSUSHITA DENKI SANGYO), 24 Décembre
1984,**

## Description

L'invention telle qu'elle est définie dans les revendications se situe dans le domaine des dispositifs de conversion d'une grandeur optique en grandeur électrique.

Dans les dispositifs transmettant un signal vidéo, par exemple un signal télévision, de façon optique, par exemple au moyen d'une fibre optique, à une extrémité de la fibre optique, ou d'une façon générale du canal lumineux où se propage l'onde optique porteuse du signal, se trouve un convertisseur d'une grandeur optique, par exemple d'énergie optique, en une grandeur électrique, par exemple une tension ou un courant. L'invention est applicable au cas où ce convertisseur est une photodiode PIN.

Une photodiode PIN est équivalente, lorsqu'elle est convenablement polarisée grâce à une tension positive appliquée entre sa cathode (jonction N) et son anode (jonction P), à un générateur de courant délivrant un courant i(t) exprimé par la relation :

$$i(t) = S \, P(t).$$

Dans cette relation,

i(t) est l'intensité instantanée du courant,
S est la sensibilité de la photodiode PIN exprimée en Ampères par Watt,
P(t) est la valeur de la puissance optique instantanée reçue par la photodiode PIN.

Les puissances optiques incidentes étant en général de faible à très faible valeur, il en est de même de la valeur du courant photodétecté et l'on conçoit qu'il faille amplifier ce dernier avec un soin extrême. Une telle qualité d'amplification est obtenue en faisant appel à un étage de préamplification dit de type transimpédance obtenu en câblant une résistance Rg entre la sortie et l'entrée e(-) d'un amplificateur de gain Gv présentant des caractéristiques assez exceptionnelles : produit gain x bande supérieur à plusieurs dizaines de GHz dans de multiples applications.

Un exemple connu de réalisation d'un tel étage de photodétection est représenté en figure 1, ou encore divulgué par le document EP-A-0 402 044.

Cette figure représente une extrémité 1 d'une fibre optique transmettant une onde lumineuse modulée par un signal vidéo fréquence. L'énergie lumineuse modulée est reçue par une photodiode PIN 2 comportant une anode (jonction P) 3, une zone intrinsèque 4 et une cathode 5. La photodiode PIN 2 est de façon connue polarisée en inverse, c'est-à-dire qu'une tension positive est appliquée sur sa cathode 5. Dans ces conditions, la photodiode PIN 2 délivre un courant qui circule de sa cathode 5 vers son anode 3. Ce courant est proportionnel à la valeur de la puissance optique incidente. Le rapport de proportionnalité représente la sensibilité de la photodiode PIN 2.

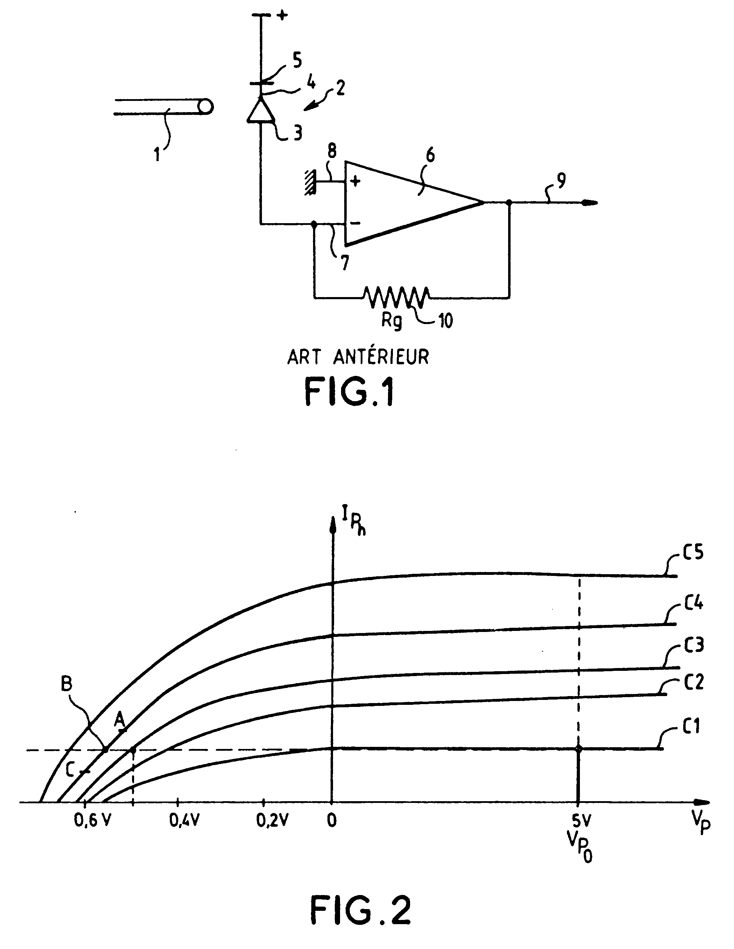

Les courbes représentant la valeur du courant photodétecté $I_{ph}$ en fonction de la tension de polarisation inverse $V_p$ sont représentées figure 2. Chacune des courbes C1... C5 de la figure 2 est la courbe représentant la valeur du courant photodétecté pour une puissance photoélectrique constante en fonction de la tension de polarisation. Lorsque cette puissance varie et que la photodiode PIN 2 est polarisée, par exemple à une valeur $V_{po}$, le point de fonctionnement de la photodiode PIN 2 va se déplacer sur une ligne verticale matérialisée sur la figure 2 par une ligne pointillée passant par la valeur $V_{po}$ et parallèle à l'axe $I_{ph}$ représentant les courants en fonction de la puissante incidente.

Le courant $I_{ph}$ est amplifié par un étage de préamplification transimpédance 6 ayant une entrée négative 7, une entrée positive 8, une sortie 9 et une résistance de contre réaction Rg 10 branchée entre la sortie 9 et l'entrée négative 7.

Il est connu que la valeur du courant de bruit ieff (Rg) due à Rg, ramenée sur l'entrée e(-) 7 de l'étage de préamplification transimpédance 6, est donnée par la relation :

$$\text{ieff (Rg)} = \frac{\alpha}{[\text{Rg}]^{\frac{1}{2}}}.$$

On conçoit tout l'intérêt qu'il puisse y avoir pour des considérations de rapport signal sur bruit à utiliser une valeur de la résistance de contre réaction Rg élevée à très élevée.

En raison du phénomène de contre réaction auquel est soumise la résistance Rg 10, la valeur apparente de la résistance de contre réaction Rg 10 vue par la photodiode PIN 2 est extrêmement faible.

Cette résistance apparente Rapp s'exprime par la relation :

$$\text{Rapp} = \frac{\text{Rg}}{\text{G} + 1}.$$

Dans cette relation, G est le gain de l'étage de préamplification transimpédance 6.

L'entrée négative 7 est ainsi équivalente à une masse virtuelle et tout le courant i(t) est dérivé en direction de la résistance de contre réaction Rg 10. Ainsi, la tension de sortie $V_s(t)$ est de la forme :

$$V_s(t) = i(t) \, \text{Rg} = S \, P_h(t) \, \text{Rg}.$$

Si la puissance optique moyenne incidente $P_h(t)$ atteint une valeur très élevée, ce qui serait le cas par exemple pour un étage détecteur situé à une extrémité d'une fibre optique de faible longueur entre émetteur et récepteur ou encore à une faible distance d'un répéteur,

la valeur de $V_s(t) = S\ P_h(t)\ Rg$ peut atteindre une valeur très élevée. Dans ces conditions, l'étage de préamplification transimpédance 6 se sature et ne fonctionne plus de façon linéaire.

Ce problème de saturation de l'étage de préamplification transimpédance 6 est connu et diverses solutions ont été utilisées pour y remédier.

Un premier mode de réalisation connu visant à éviter la saturation de l'étage de préamplification transimpédance 6 consiste à utiliser une résistance de contre réaction Rg 10 de faible valeur de telle sorte que $V_s(t)$ max $= i(t)$ max Rg n'excède pas la valeur de $V_s$ maximum admissible. Cette solution se solde par une dégradation du rapport signal sur bruit intrinsèque du récepteur optique en raison de l'augmentation du terme

$$\mathrm{ieff}\ (Rg) = \frac{\alpha}{[Rg]^{\frac{1}{2}}}.$$

Dans cette expression, $\alpha$ est un coefficient de proportionnalité.

Un second mode de réalisation connu visant à éviter la saturation de l'étage de préamplification transimpédance 6 consiste à insérer un atténuateur dans la liaison optique pour éviter que P(t) excède la valeur maximum admissible P(t) maximum. Cette contrainte d'optimisation individuelle de chaque liaison n'est plus acceptée à ce jour par les utilisateurs.

Ce mode de réalisation oblige ces derniers à mesurer ou calculer la puissance optique moyenne incidente pour déterminer la valeur de l'atténuateur à insérer.

Enfin, une troisième solution connue consiste à substituer une photodiode à avalanche à la photodiode PIN 2. Une photodiode à avalanche est équivalente à une photodiode PIN qui serait caractérisée par une sensibilité :

$$S_1 = M\ S,$$

S étant la sensibilité d'une photodiode PIN classique,

M étant un coefficient compris entre 1 et $\equiv$ 20. La valeur du facteur de multiplication M est fonction de la valeur de la tension de polarisation de la photodiode à avalanche. En exploitant cette propriété, on peut grâce à une boucle de contre réaction électrique asservir la valeur de M à la valeur de la puissance optique incidente sur l'étage photodétecteur.

Cette solution performante présente l'inconvénient d'être extrêmement onéreuse, d'une part en raison du prix d'une diode à avalanche comparé au prix d'une photodiode PIN et d'autre part en raison du prix des circuits électroniques d'asservissement de la diode à avalanche.

La présente invention vise un étage de préamplification transimpédance utilisant une photodiode PIN de détection dont le courant moyen de sortie reste inférieur au courant provoquant la saturation de l'étage de préamplification transimpédance, ceci sans diminuer la valeur du rapport signal/bruit de cet étage de préamplification transimpédance. On veut dire par là qu'avec une même valeur théorique de rapport signal/bruit, le dispositif selon l'invention présente une dynamique de puissance lumineuse incidente plus grande que les dispositifs à photodiode PIN selon l'art antérieur. Dit encore autrement pour une même résistance de contre réaction Rg de l'étage de préamplification transimpédance, le dispositif selon l'invention présente une plus grande dynamique de réception de puissance lumineuse que les dispositifs à photodiode PIN de l'art antérieur.

Ainsi, le dispositif selon l'invention pourra être employé sans précautions ou réglages particuliers, à une extrémité d'une fibre optique dont l'autre extrémité reçoit une puissance lumineuse d'un émetteur, ou d'un répéteur, ceci, pratiquement quelle que soit la distance entre l'émetteur ou le répéteur et le dispositif selon l'invention. En particulier, il ne sera plus nécessaire, comme dans la première réalisation de l'art antérieur, de régler la valeur de la résistance de contre réaction Rg, pour la diminuer lorsque la distance à la source diminue, ce qui paradoxalement augmente alors le bruit de l'étage et donc diminue le rapport signal/bruit. Il ne sera pas nécessaire non plus, comme dans la seconde réalisation de l'art antérieur, de diminuer la puissance lumineuse reçue au moyen d'un atténuateur lorsque la puissance lumineuse moyenne reçue par la photodiode PIN augmente, par exemple en raison de la brièveté de la ligne optique entre le dernier répéteur et le dispositif selon l'invention.

En résumé, l'utilisation du dispositif photodétecteur à photodiode PIN selon l'invention libère l'utilisateur de tout souci d'adaptation du dispositif au niveau moyen de la puissance optique reçue localement. L'adaptation se fait automatiquement.

Pour garder la valeur moyenne du courant de modulation photodétecté par la photodiode PIN, il est prévu selon la présente invention de diminuer au-delà d'un certain seuil de puissance lumineuse moyenne reçue $P_h$ seuil la sensibilité de la photodiode PIN.

Au-delà de ce seuil $P_h$ seuil, le courant moyen généré par la photodiode PIN reste constant.

Ainsi, l'invention est-elle relative à un dispositif de détection d'un signal porté par une onde lumineuse modulée, le dispositif recevant l'onde sur une photodiode PIN ayant deux électrodes, une anode et une cathode, ainsi qu'une partie intrinsèque, l'une au moins des électrodes de la photodiode PIN étant connectée à des moyens de polarisation, la photodiode PIN délivrant lorsqu'elle est polarisée en inverse par une tension positive appliquée entre sa cathode et son anode, un courant de photodétection i(t) proportionnel à la puissance de l'onde lumineuse incidente, dispositif de détection

caractérisé en ce que les moyens de polarisation de la photodiode PIN sont capables d'appliquer à la photodiode PIN deux états de polarisation, un premier et un second, la polarisation s'établissant automatiquement dans le premier ou dans le second état en fonction de la puissance lumineuse moyenne reçue, dans le premier état correspondant à des puissances lumineuses moyennes reçues inférieures à une valeur seuil $P_h$seuil, la photodiode est polarisée en inverse par les moyens de polarisation ; dans le second état correspondant à des puissances moyennes lumineuses reçues supérieures à la valeur seuil $P_h$seuil, la photodiode est polarisée en direct par lesdits moyens de polarisation, le courant moyen de photodétection délivré par la photodiode étant alors constant.

Un exemple préféré de réalisation et d'autres modes de réalisation de l'invention seront décrits ci-après en relation aux dessins annexés dans lesquels :

-    La figure 1 déjà décrite représente une photodiode PIN de détection d'un signal lumineux, branchée entre une source de polarisation inverse et un étage de préamplification transimpédance conformément à l'art antérieur connu.
-    La figure 2 représente un réseau de courbes C1 à C5, chaque courbe représente pour une puissance lumineuse reçue constante, la valeur du courant photodétecté $I_{ph}$ en fonction de la tension de polarisation appliquée à une photodiode PIN.
-    La figure 3 représente une photodiode PIN équipée de moyens de polarisation selon un mode préféré de réalisation de l'invention, ainsi que l'étage de préamplification transimpédance auquel elle est couplée.
-    Les figures 4 et 5 sont des courbes représentant chacune en fonction du temps un exemple volontairement très simple de puissance lumineuse reçue.
-    La figure 6 représente les mêmes moyens de polarisation que ceux de la figure 3, mais connectés selon un mode inverse équivalent.

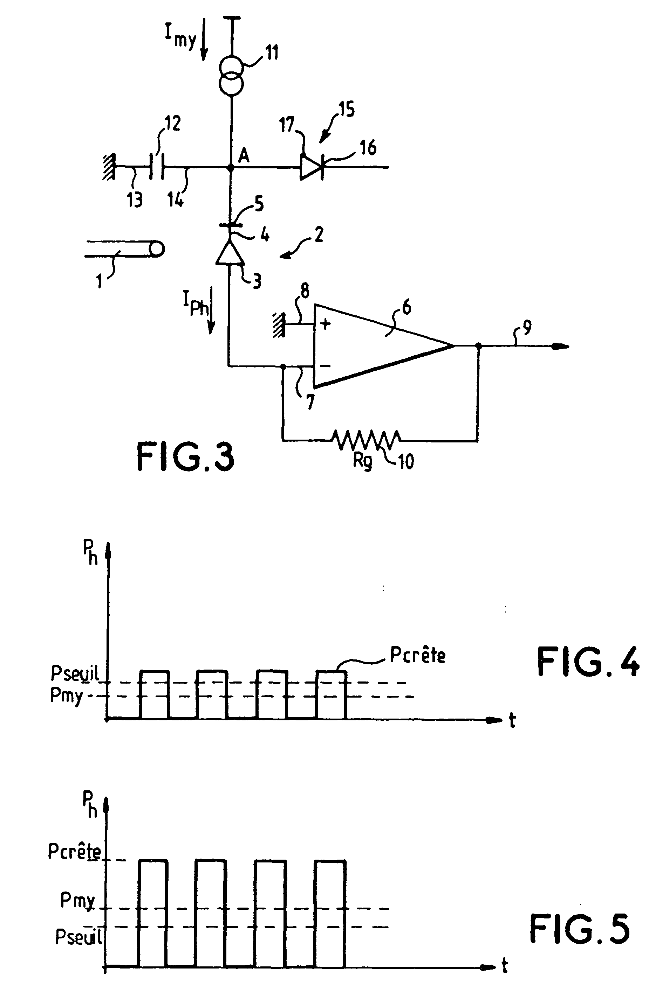

Dans les différentes figures, les éléments ayant même fonction portent le même numéro de référence. En particulier dans la figure 3, qui sera ci-après décrite, les éléments ayant même fonction que ceux de la figure 1 portent le même numéro de référence.

Ainsi sur la figure 3, une photodiode PIN 2 comportant une anode 3, une zone intrinsèque 4 et une cathode 5, est alimentée par une source lumineuse modulée, représentée schématiquement dans cet exemple de réalisation par une extrémité 1 d'une fibre optique. L'anode 3 de la photodiode 2 est connectée à une entrée négative d'un étage de préamplification transimpédance 6. L'entrée positive de cet étage de préamplification transimpédance 6 est dans cet exemple connectée à la masse. Une résistance de contre réaction Rg 10 est connectée entre la sortie 9 de l'étage de préamplification transimpédance 6 et l'entrée négative 7.

Selon un mode préféré de réalisation de l'invention, des moyens de polarisation sont connectés par exemple en un point A à la cathode 5 de la photodiode PIN 2. Dans l'exemple représenté, ces moyens comprennent, connectés au point A, un générateur de courant constant 11, une capacité 12 ayant deux connections 13 et 14 dont l'une 14 est raccordée au point A, une diode 15 ayant une cathode 16 et une anode 17. L'anode 17 de la diode 15 est connectée au point A. Ainsi, le générateur de courant constant 11, l'anode 17 de la diode 15 et une connexion 14 de la capacité 12 sont connectés au point A à la cathode 5 de la photodiode PIN 2. Les moyens 11, 12 et 15 constituent, dans cet exemple de réalisation, les moyens de polarisation de la photodiode PIN 2.

Le fonctionnement de ces moyens sera maintenant explicité en référence aux figures 2, 3, 4 et 5. Les figures 4 et 5 sont des courbes qui représentent chacune en fonction du temps une puissance lumineuse incidente sur la photodiode PIN 2. Ces courbes sont constituées par une succession de puissances nulles puis positives se succédant alternativement pendant des périodes égales. Sur la figure 4, le niveau positif $P_h$crête est tel que la puissance moyenne reçue est inférieure à une puissance seuil $P_h$seuil déterminée de façon connue à partir de la tension de saturation de l'étage de préamplification transimpédance 6. Ce cas, qui correspond au cas où la source émettrice est relativement loin de la photodiode PIN 2, correspond au premier état de polarisation du dispositif selon l'invention. Sur la figure 5, le niveau positif $P_h$crête est tel que la puissance moyenne reçue est supérieure à une puissance seuil $P_h$seuil déterminée de façon connue à partir de la tension de saturation de l'étage de préamplification transimpédance 6. Ce cas, qui correspond au cas où la source émettrice se trouve relativement près de la photodiode PIN 2, correspond au second état de polarisation du dispositif selon l'invention. Naturellement, puisqu'il s'agit du même étage de préamplification transimpédance 6 dans les deux cas, la puissance moyenne lumineuse qui provoque une tension de sortie saturant l'étage de préamplification transimpédance 6 est la même. De même, dans les deux cas choisis ici volontairement simples à des fins didactiques, la puissance moyenne reçue est égale à la moitié de la valeur crête de la puissance lumineuse reçue.

Sur les figures 4 et 5, la puissance moyenne reçue est matérialisée par une droite en pointillés, parallèle à l'axe des temps et située au niveau $P_{my}$. Le niveau $P_{my}$ a la valeur moitié du niveau $P_h$crête. Le niveau $P_h$seuil est également représenté par une parallèle à l'axe des temps. Sur la figure 4, le niveau $P_{my}$ est inférieur au niveau $P_h$seuil. C'est l'inverse sur la figure 5.

Il sera maintenant examiné comment se comporte le dispositif selon l'invention, représenté figure 3, lorsque la puissance lumineuse moyenne incidente est inférieure à la puissance seuil $P_h$seuil (cas de la figure 4). On notera tout d'abord que le générateur de courant constant 11 délivre un courant programmé à l'avance $I_{my}$ circulant du générateur de courant constant 11 vers le point A. Le courant $I_{my}$ est tel qu'une tension aux bornes de la résistance de contre réaction Rg 10 ayant la valeur $I_{my}$ x Rg soit inférieure à la tension de saturation de l'étage de préamplification transimpédance 6.

Lorsque la source de courant est branchée, il y a dans une phase transitoire, tout d'abord charge de la capacité 12. Le potentiel du point A augmente. Lorsque ce potentiel est suffisant pour rendre conductrice la diode 15, la capacité 12 cesse de se charger. Le courant $I_{my}$ est dévié vers la diode 15 qui est conductrice. La photodiode PIN 2 est polarisée en inverse, c'est-à-dire qu'une tension positive est appliquée sur sa cathode 5. Le point de polarisation est par exemple à la valeur $V_{po}$ portée sur l'axe des abscisses de la figure 2. Lorsqu'une puissance lumineuse est appliquée à la photodiode PIN 2, un courant s'établit entre la cathode 5 et l'anode 3 de la photodiode PIN 2, soit $I_{ph}$ ce courant. Le générateur de courant 11 étant constant, il passe alors dans la diode 15 un courant

$I_{my} - I_{ph}$.

La tension au point A reste égale à $V_{po}$. Le point de fonctionnement de la photodiode PIN 2 est toujours défini par la tension de polarisation $V_{po}$. Si momentanément comme représenté volontairement figure 4, la puissance $P_h$crête de photodétection devient supérieure à la puissance seuil $P_h$seuil, cela signifie que momentanément, le courant instantané $I_{ph}$ est supérieur à $I_{my}$. La différence $I_{my} - I_{ph}$ devenant négative, cela signifie que la capacité 12 va se décharger. La valeur de la tension au point A va baisser et bloquer la diode 15. Si la durée pendant laquelle $I_{ph}$ est supérieur à $I_{my}$ est suffisamment courte, la chute de tension sera légère et cela n'affectera pas le fonctionnement de la photodiode PIN 2, dans la mesure où comme représenté figure 2, dans une large plage autour de $V_{po}$, les courbes C1 à C5 donnant la valeur du courant photodétecté en fonction de la polarisation, paramétrées par la valeur du courant photodétecté, sont assimilables à des droites parallèles à l'axe des abscisses.

Quel que soit le point de polarisation autour d'une valeur voisine de $V_{po}$, la réponse de la photodiode PIN 2, c'est-à-dire la valeur du courant $I_{ph}$ est la même et ne dépend que de la valeur de la puissance lumineuse reçue.

Lorsque la puissance photodétectée redevient inférieure à la puissance seuil $P_h$seuil, la valeur du courant $I_{my} - I_{ph}$ redevient positive, la capacité 12 va bénéficier d'un courant de charge. La tension au point A va augmenter jusqu'à rendre conductrice la diode 15. Ainsi, lorsque la valeur moyenne du courant photodétecté est de façon stable inférieure à celle du courant délivré par le générateur de courant constant 11, la photodiode PIN 2 est polarisée de façon stable en inverse. Des courants photodétectés momentanément supérieurs au courant délivré par le générateur de courant constant 11 n'affectent pas le comportement de la photodiode PIN 2.

Il va maintenant être examiné comment se comporte le dispositif de polarisation selon l'invention lorsque la puissance lumineuse moyenne incidente est de façon stable supérieure à la puissance seuil $P_h$seuil. Le générateur de courant constant 11 délivre le même courant que dans le cas précédent. Ce courant ne dépend que des caractéristiques de l'étage de préamplification transimpédance 6.

On va supposer que la réception du signal détecté a commencé après la mise en route du dispositif selon l'invention. Comme expliqué précédemment, à la fin d'une phase transitoire la tension au point A est telle que la diode 15 conduit. La photodiode PIN 2 est polarisée en inverse à la valeur $V_{po}$.

Chaque fois que la valeur du courant délivré par la photodiode PIN 2 va être supérieure au courant $I_{my}$ délivré par le générateur de courant constant 11, la capacité 12 va se décharger avec un courant de décharge $I_{ph} - I_{my}$. Le potentiel en A va baisser, la diode 15 va être bloquée. A l'inverse du cas précédent, les périodes de recharge de la capacité 12 et les valeurs du courant de recharge correspondant aux périodes où la puissance photodétectée est inférieure à la puissance seuil $P_h$seuil seront insuffisantes pour recharger la capacité 12. Par hypothèse et comme représenté figure 5, le courant photodétecté est en moyenne supérieur au courant délivré par le générateur de courant constant 11. Il en résulte que la capacité 12 va se décharger régulièrement et même se charger de telle sorte que la tension au point A va devenir négative. La photodiode PIN 2 va se trouver polarisée en direct. La valeur du courant photodétecté délivré par la photodiode PIN 2 lorsqu'elle est polarisée en direct est représentée sur la partie gauche de la figure 2. L'échelle des abscisses est sur cette partie gauche supérieure à celle de la partie droite de façon à mieux rendre perceptible les courbes C1 à C5.

Ainsi, lorsque la valeur moyenne du courant photodétecté tend à être de façon stable supérieure au courant Img programmé, la photodiode PIN 2 se polarise en direct. La valeur moyenne du courant photodétecté se stabilise à la valeur $I_{my}$ programmée. Une telle stabilisation est due au phénomène ci-après : en raison de la chute de tension entre anode 3 et cathode 5 de la photodiode PIN 2, le champ électrique dans la zone intrinsèque 4 de la photodiode PIN 2 devient faible et insuffisant pour assurer une bonne séparation des paires électrons-trous positifs. Il y a donc une certaine recombinaison des paires électrons-trous positifs libérées dans la zone intrinsèque 4 sous l'effet des photons incidents. Un état d'équilibre s'instaure entre la valeur de la tension de polarisation directe résultant de la décharge de la capacité 12 et le pourcentage de recombinaison des paires électrons-trous positifs. L'état d'équilibre est tel que la valeur moyenne du courant photodétecté s'établit à la valeur du courant $I_{my}$ délivré par le générateur de courant constant 11. Ce point de fonctionnement se déplace sur une droite parallèle à l'axe des abscisses. Cette droite est représentée sur la partie gauche de la figure 2.

En raison de la présence du condensateur 12, la sensibilité obtenue pour une certaine valeur de puissance lumineuse moyenne reste découplée de la valeur de la sensibilité instantanée. Ainsi alors que le point de fonctionnement est déterminé par la valeur moyenne de la puissance incidente, le point de fonctionnement instantané se déplace sur la courbe C correspondant à ce point. Ainsi, sur la figure 2, si l'on admet que le point de fonctionnement s'établit sur la courbe C4 au point B intersection de la courbe C4 et de la droite $I_{ph} = I_{my}$, le point de fonctionnement instantané de la photodiode PIN 2 se déplace sur la courbe C4 par exemple entre les points C et D. Les déplacements lents et faibles du point de fonctionnement B autour de sa position d'équilibre due aux variations lentes de tension du condensateur 12, n'affectent pas de façon sensible la sensibilité instantanée. Cela est dû au fait que pour de petits déplacements de B les courbes C peuvent être considérées comme localement parallèles.

Ainsi, l'on voit qu'avec des moyens simples, on déplace le point de fonctionnement de la photodiode PIN 2 de façon automatique. Dans un premier cas qui correspond à une puissance optique incidente moyenne inférieure à une valeur seuil $P_h$seuil réglable, la photodiode PIN 2 est polarisée en inverse et fonctionne de la façon connue. Dans un second cas qui correspond à une puissance optique incidente moyenne supérieure à cette valeur seuil $P_h$seuil, la photodiode PIN 2 est polarisée en direct. La polarisation inverse ou directe s'établit automatiquement en fonction de la puissance moyenne incidente.

En polarisation directe, la solution selon l'invention confère -au-delà d'une certaine puissance optique incidente $P_h$seuil- à la photodiode PIN 2 une sensibilité inversement proportionnelle à la valeur de la puissance optique P incidente. Ainsi, au-delà de cette puissance, la valeur du courant photodétecté est indépendante de la valeur de la puissance optique moyenne incidente.

Les moyens de polarisation décrits en relation avec la figure 3 présentent l'avantage de la simplicité. L'homme du métier peut cependant aisément trouver d'autres moyens pour déplacer le point de fonctionnement en fonction de la puissance moyenne incidente reçue par la photodiode PIN 2.

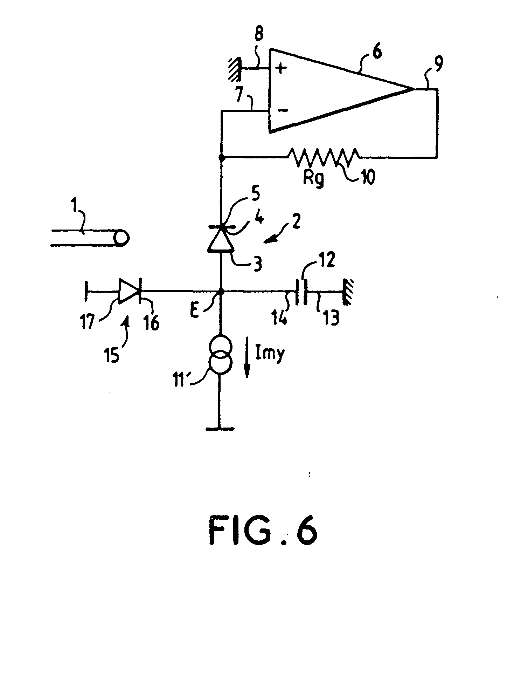

Tout d'abord, et de façon évidente, ces mêmes moyens peuvent être appliqués à l'anode 3, et non pas à la cathode 5, de la photodiode PIN 2. Un tel cas est représenté figure 6.

Cette figure représente les mêmes éléments que ceux de la figure 3 mais dans le cas de la figure 6, les moyens de polarisation de la photodiode PIN 2 sont connectés en un point E raccordé à l'anode 3 de la photodiode PIN 2. Dans ce mode de connexion, c'est la cathode 16 de la diode de polarisation 15 qui est raccordé au point E. Le courant généré par le générateur de courant constant 11 est dans ce cas dirigé du point E vers le générateur de courant constant 11. Le fonctionnement est le même que dans le cas précédent.

Dans un autre mode de réalisation non représenté, la diode de polarisation 15 pourrait être remplacée par un transistor ayant sa base raccordée au point E.

Enfin, l'homme du métier peut concevoir d'autres moyens de polarisation, ces moyens étant connectés dans une voie parallèle à la photodiode PIN 2 et étant alors connectés à l'une et l'autre des électrodes de cette photodiode PIN 2.

## Revendications

1. Dispositif de détection d'un signal porté par une onde lumineuse modulée, le dispositif recevant l'onde sur une photodiode PIN (2) ayant deux électrodes (3, 5), une anode (5) et une cathode (3), ainsi qu'une partie intrinsèque (4), l'une au moins des électrodes (3, 5) de la photodiode PIN (2) étant connectée à des moyens de polarisation, la photodiode PIN (2) délivrant lorsqu'elle est polarisée en inverse par une tension positive appliquée entre sa cathode (3) et son anode (5), un courant de photodétection i(t) proportionnel à la puissance de l'onde lumineuse incidente, dispositif de détection **caractérisé en ce que** les moyens de polarisation de la photodiode PIN (2) sont capables d'appliquer à la photodiode PIN (2) deux états de polarisation, un premier et un second, la polarisation s'établissant automatiquement dans le premier ou dans le second état en fonction de la puissance lumineuse moyenne reçue, et **en ce que** dans le premier état correspondant à des puissances lumineuses moyennes reçues inférieures à une valeur seuil $P_h$seuil, la photodiode PIN 2 est polarisée en inverse par les moyens de polarisation, et **en ce que** dans le second état correspondant à des puissances moyennes lumineuses reçues supérieures à la valeur seuil $P_h$seuil, la photodiode est polarisée en direct par lesdits moyens de polarisation, le courant moyen de photodétection délivré par la photodiode étant alors constant.

2. Dispositif de détection selon la revendication 1, **caractérisé en ce que** les moyens de détection comportent, connectés à l'une des électrodes (3, 5) de la photodiode PIN (2), une diode de polarisation (15) ayant deux électrodes (16, 17), une anode (17) et une cathode (16), une capacité (12) ayant deux connections (13, 14) et un générateur de courant constant (11, 11').

3. Dispositif selon la revendication 2, **caractérisé en ce que** l'anode (17) de la diode de polarisation (15), une connexion (14) de la capacité (12) et le générateur de courant constant (11) sont connectés à la cathode (5) de la photodiode PIN (2).

4.  Dispositif selon la revendication 2, **caractérisé en ce que** la cathode (16) de la diode de polarisation (15), une connexion (14) de la capacité (12) et le générateur de courant constant (11') sont connectés à l'anode (3) de la photodiode PIN (2).

## Claims

1.  Device for detecting a signal carried by a modulated light wave, the device receiving the wave on a PIN photodiode (2) having two electrodes (3, 5), an anode (5) and a cathode (3), as well as an intrinsic part (4), at least one of the electrodes (3, 5) of the PIN photodiode (2) being connected to biasing means, the PIN photodiode (2) delivering, when it is reverse-biased by a positive voltage applied between its cathode (3) and its anode (5), a photodetection current i(t) proportional to the power of the incident light wave, which detection device is **characterized in that** the means for biasing the PIN photodiode (2) are capable of applying two bias states to the PIN photodiode (2), a first bias state and a second bias state, the bias being automatically established in the first or in the second state depending on the average received light power, and **in that** in the first state, corresponding to average received light powers below a threshold value $P_h$threshold, the PIN photodiode 2 is reverse-biased by the biasing means, and **in that** in the second state, corresponding to average received light powers greater than the threshold value $P_h$threshold, the photodiode is forward-biased by the said biasing means, the average photodetection current delivered by the photodiode then being constant.

2.  Detection device according to Claim 1, **characterized in that** the detection means include, connected to one of the electrodes (3, 5) of the PIN photodiode (2), a biasing diode (15) having two electrodes (16, 17), an anode (17) and a cathode (16), a capacitor (12) having two connections (13, 14) and a constant-current generator (11, 11').

3.  Device according to Claim 2, **characterized in that** the anode (17) of the biasing diode (15), a connection (14) of the capacitor (12) and the constant-current generator (11) are connected to the cathode (5) of the PIN photodiode (2).

4.  Device according to Claim 2, **characterized in that** the cathode (16) of the biasing diode (15), a connection (14) of the capacitor (12) and the constant-current generator (11') are connected to the anode (3) of the PIN photodiode (2).

## Patentansprüche

1.  Einrichtung zur Detektion eines durch eine modulierte Lichtwelle übertragenen Signals, wobei die Einrichtung die Welle auf einer PIN-Fotodiode (2) mit zwei Elektroden (3, 5), einer Anode (5) und einer Kathode (3) sowie einem intrinsischen Halbleiterteil (4) empfängt, und wenigstens eine der Elektroden (3, 5) der PIN-Fotodiode (2) mit Vorspannungsmitteln verbunden ist und die PIN-Fotodiode (2) dann, wenn sie durch eine zwischen ihrer Kathode (3) und ihrer Anode (5) angelegte positive Spannung in Sperrichtung vorgespannt ist, einen Fotodetektionsstrom i(t) proportional zu der Leistung der einfallenden Lichtwelle liefert,
    **dadurch gekennzeichnet, daß**
    die Vorspannungsmittel für die PIN-Fotodiode (2) in der Lage sind, an die PIN-Fotodiode (2) zwei Vorspannungszustände, einen ersten und einen zweiten, anzulegen, daß die Vorspannung in Abhängigkeit von der empfangenen mittleren Lichtleistung selbsttätig in den ersten oder den zweiten Zustand übergeht, und daß in dem ersten Zustand, der empfangenen mittleren Lichtleistungen unterhalb eines Schwellwertes $P_h$seuil entspricht, die PIN-Fotodiode 2 durch die Vorspannungsmittel in Sperrichtung vorgespannt ist, und daß in dem zweiten Zustand, der empfangenen mittleren Lichtleistungen oberhalb des Schwellwertes $P_h$seuil entspricht, die Fotodiode durch die Vorspannungsmittel in Durchlaßrichtung vorgespannt ist, und daß dann der durch die Fotodiode gelieferte mittlere Strom der Fotodetektion konstant ist.

2.  Einrichtung zur Detektion nach Anspruch 1, **dadurch gekennzeichnet, daß** die Detektionsmittel jeweils an eine der Elektroden (3, 5) der PIN-Fotodiode (2) angeschlossene Vorspannungsdiode (15) mit zwei Elektroden (16, 17), einer Anode (17) und einer Kathode (16), eine Kapazität (12) mit zwei Anschlüssen (13, 14) und einen Konstantstromgenerator (11, 11') enthalten.

3.  Einrichtung nach Anspruch 2, **dadurch gekennzeichnet, daß** die Anode (17) der Vorspannungsdiode (15), ein Anschluß (14) der Kapazität (12) und der Konstantstromgenerator (11) mit der Kathode (5) der PIN-Fotodiode (2) verbunden sind.

4.  Einrichtung nach Anspruch 2, **dadurch gekennzeichnet, daß** die Kathode (16) der Vorspannungsdiode (15), ein Anschluß (14) der Kapazität (12) und der Konstantstromgenerator (11') mit der Anode (3) der PIN-Fotodiode (2) verbunden sind.

ART ANTÉRIEUR

# FIG.1

# FIG.2

FIG.3

FIG.4

FIG.5

9

FIG.6